# EUROPEAN PATENT SPECIFICATION

(11) **EP 3 462 197 B1**
(45) Date of publication and mention of the grant of the patent: **12.08.2020**
(21) Application number: 17194051.3
(22) Date of filing: 29.09.2017
(51) Int. Cl.: G01R 31/28, H04M 1/24, H04M 3/28

(54) **INTEGRATED CIRCUIT CARD TEST UNIT, TEST SYSTEM AS WELL AS METHOD FOR TESTING A DEVICE UNDER TEST**
TESTEINHEIT FÜR KARTE MIT INTEGRIERTER SCHALTUNG, TESTSYSTEM SOWIE VERFAHREN ZUM TESTEN EINER ZU TESTENDEN VORRICHTUNG
UNITÉ D'ESSAI DE CARTE DE CIRCUIT INTÉGRÉ, SYSTÈME DE TEST AINSI QUE PROCÉDÉ PERMETTANT DE TESTER UN DISPOSITIF SOUS TEST

(43) Date of publication of application: 03.04.2019
(73) Proprietor: Rohde & Schwarz GmbH & Co. KG, 81671 München (DE)
(72) Inventor: Hoetzl, Felix, 82276 Adelshofen (DE); Brunnbauer, Roland, 94481 Grafenau (DE)
(74) Representative: Prinz & Partner mbB

(56) References cited:
- US-A1- 2017 013 121

## Description

The invention relates to an integrated circuit card test unit and a test system for testing a device under test. Further, the invention relates to a method for testing a device under test.

Modern communication devices such as mobile phones or cellular phones have to be tested with different integrated circuit cards such as SIM-cards (also called USIM cards) and different integrated circuit card profiles. The integrated circuit cards are also known as smart cards or chip cards. For certificating mobile communication devices, it is required to use physical integrated circuit cards, for instance SIM-cards, for the testing of the device under test. During a certain test scenario or during the certificating, more than 120 different profiles and cards have to be investigated in order to verify and certificate the communication device completely such that a full coverage of the different applications is ensured, namely the different combinations of cards and profiles. However, these tests are expensive and time-consuming since the different physical integrated circuit cards have to be exchanged manually.

Further, the manual exchange of the integrated circuit cards is fault-prone as the different integrated circuit cards with the different profiles may be interchanged by mistake.

Since the mobile communication certification requires the usage of physical integrated circuit cards, simulators cannot be used for certification purposes such that an automatic test scenario for testing a device under test with different integrated circuit cards is not applicable at the moment. Due to the manual exchange of the integrated circuit cards, the tests have to be performed during the work time of the person that carries out the respective tests.

US 2017/0013121 A1 shows a testing method and system for mobile communication devices wherein a single integrated circuit card slot is provided.

Accordingly, there is a need for a possibility to test a device under test in a more cost-efficient and simple manner. This object is solved by the subject matter of the independent claims. Preferred embodiments are defined by the dependent claims.

The invention provides an integrated circuit card test unit for testing a device under test, comprising:
- a first integrated circuit card slot,
- a second integrated circuit card slot,
- a switch unit,
- an integrated circuit card controller,
- an integrated circuit card adaptor establishing an interface for the device under test, and
- a switch control interface, wherein

the switch unit is connected to the first integrated circuit card slot, the second integrated circuit card slot, the integrated circuit card controller, and the integrated circuit card adaptor, wherein

the switch unit has at least a first operation mode in which a connection between either the first integrated circuit card slot or the second integrated circuit card slot and the integrated circuit card adaptor is established via the switch unit, wherein

the switch unit has at least a second operation mode in which a connection between either the first integrated circuit card slot or the second integrated circuit card slot and the integrated circuit card controller is established via the switch unit, and wherein

the switch unit is configured to selectively connect either the first or the second integrated circuit card slot to the integrated circuit card controller and, respectively, the second or first integrated circuit card slot to the integrated circuit card adaptor.

The invention is based on the finding that the testing of the device under test can be automated while using the integrated circuit card test unit (ICC test unit) that provides at least two different integrated circuit card slots for accommodating two physical integrated circuit cards. The physical integrated circuit cards used for the testing may be inserted in the respective integrated circuit card slots wherein they have a certain integrated circuit card profile, respectively. As both integrated circuit card slots are connected to the switch unit that is also connected to the integrated circuit card adaptor establishing the interface for the device under test, both physical integrated circuit cards may be used for the testing in general. In the first operation mode, one of both physical cards inserted in the respective slot is connected to the integrated circuit card adaptor such that this physical card and its profile can be used for testing the device under test. The ICC test unit may automatically change the connection from the first integrated circuit card slot to the second integrated circuit card slot such that the other physical ICC card is connected to the ICC adaptor. Thus, the switch unit is configured to selectively connect either the first or the second integrated circuit card slot to the integrated circuit card adaptor, in particular in a subsequent manner. Hence, both integrated circuit cards with their respective profiles can be used for the testing in a subsequent manner in the first operation mode.

Thus, the programming operation corresponds to the second operation mode of the ICC test unit as the ICC controller may program the physical ICC that is connected to the ICC controller via the respective ICC slot.

Thus, the integrated circuit card adaptor and/or the integrated circuit card controller are/is connected with only one ICC slot via the switch unit simultaneously.

According to an aspect, the integrated circuit card controller is configured to provision a physical integrated circuit card connected to the first integrated circuit card slot or the second integrated circuit card slot with a predetermined integrated circuit card profile. Thus, the integrated circuit card test unit, in particular the integrated circuit card controller, is configured to program the physical integrated circuit cards inserted in one of the slots by applying a certain ICC profile. The appropriate ICC profile is written on the physical ICC. Therefore, it is possible to use more integrated circuit card profiles than integrated circuit cards are provided since the integrated circuit cards can be (re-)programmed appropriately by the ICC test unit, in particular its ICC controller.

The first operation mode and the second operation mode may be established by a common operation mode, in particular wherein, in the common operation mode, a connection between the first integrated circuit card slot and the integrated circuit card adaptor and a connection between the second integrated circuit card slot and the integrated circuit card controller are established or wherein, in the common operation mode, a connection between the second integrated circuit card slot and the integrated circuit card adaptor and a connection between the first integrated circuit card slot and the integrated circuit card controller are established. Accordingly, the switch unit may establish two connections simultaneously wherein the first connection is provided between one of both integrated circuit card slots and the integrated circuit card adaptor and the second connection is provided between the other of both integrated circuit card slots with the integrated circuit card controller. Accordingly, it is possible that one physical integrated circuit card is used for testing the device under test wherein the other physical integrated circuit card is reprogrammed by the integrated circuit card controller simultaneously. Thus, the overall testing time can be reduced.

Further, the integrated circuit card controller may comprise a writer unit and/or a reader unit. The integrated circuit card controller is configured to read the ICC profile of the physical integrated circuit card that is inserted into the ICC slot being connected to the ICC controller via the switch unit. In addition, the ICC controller may overwrite the current ICC profile of the physical ICC inserted into the ICC slot that is connected to the ICC controller if desired. If the ICC controller, in particular its reader unit, identifies that the current ICC profile was already tested, the ICC controller, in particular its writer unit, will overwrite the current ICC profile with a new one to be tested.

Another aspect provides that the switch control interface comprises a power supply unit and a data transmission unit. Therefore, the whole ICC test unit can be supplied with the required power via the switch control interface that may be established by a Universal Serial Bus interface (USB interface). Furthermore, appropriate control signals may be forwarded via the switch control interface in order to control the switch unit.

Particularly, the switch unit has a switching matrix function. Thus, the switch unit is configured to establish at least more than one connection simultaneously wherein the different connections may be varied.

Further, the invention provides a test system for testing a device under test, wherein the test system comprises a device under test and an integrated circuit card test unit as mentioned above. The test system is enabled to test the device under test, for instance for certificating purposes. The above mentioned advantages of the ICC test unit also apply for the test system in a similar manner.

Particularly, the device under test is connected with the integrated circuit card adaptor via a cable, in particular wherein the cable is connected to a SIM-card slot of the device under test. Thus, the data exchange of the ICC test unit and the device under test may be established via a stable cable connection.

For instance, the device under test is a mobile end device, in particular a communication device. The mobile end device, also called user equipment, may be a smartphone, a cellular phone or a tablet.

Further, the invention provides a method for testing a device under test by using an integrated circuit card test unit, wherein, in a first test step, a connection between a first of at least two integrated circuit card slots and an integrated circuit card adaptor is established, wherein the integrated circuit card adaptor corresponds to an interface for the device under test, wherein, in a second test step, a second of at least two integrated circuit card slots is connected to the integrated circuit card adaptor, and wherein the first integrated circuit card slot is connected to the integrated circuit card controller during the second test step and/or wherein the second integrated circuit card slot is connected to the integrated circuit card controller during the first test step. The ICC test unit is enabled to connect the device under test with at least two different physical integrated circuit cards that are inserted into the different integrated circuit card slots of the ICC test unit.

Thus, the testing of the device under test may comprise at least two different test steps wherein two different integrated circuit cards are connected to the device under test subsequently in order to test the device under test with at least two different integrated circuit card profiles.

Thus, one of both integrated circuit card slots, in particular the integrated circuit card inserted in the respective slot, is connected to the device under test for testing purposes whereas the other integrated circuit card is connected to the ICC controller for programming purposes. The programming and testing may be done simultaneously.

Another aspect provides that the first integrated circuit card slot or the second integrated circuit card slot is connected to an integrated circuit card controller in order to program a physical integrated circuit card inserted with a predetermined integrated circuit card profile used for testing the device under test. Therefore, the ICC profile may be changed in an automatic manner since the current ICC profile of at least one physical ICC is overwritten. Since the integrated circuit card test unit comprises two different ICC slots, at least one physical integrated circuit card can be (re-)programmed during the testing of the device under test.

In general, the first and the second test steps may correspond to a first operation mode of the ICC test unit whereas the programming corresponds to a second operation mode of the ICC test unit. However, the ICC test unit comprises a common operation mode in which both, the first operation mode and the second operation mode, are carried out simultaneously such that one physical ICC is used for the testing and the other ICC is (re-)programmed.

For instance, the integrated circuit card test unit is an integrated circuit card test unit as described above. The above mentioned advantages also apply to the method in a similar manner.

In general, the ICC profile may be a universal integrated circuit card profile (UICC profile).

The invention will now be described with reference to the enclosed drawings. In the drawings,
- Figure 1 schematically shows a first embodiment of a test system according to the invention, and
- Figure 2 schematically shows a second embodiment of a test system according to the invention.

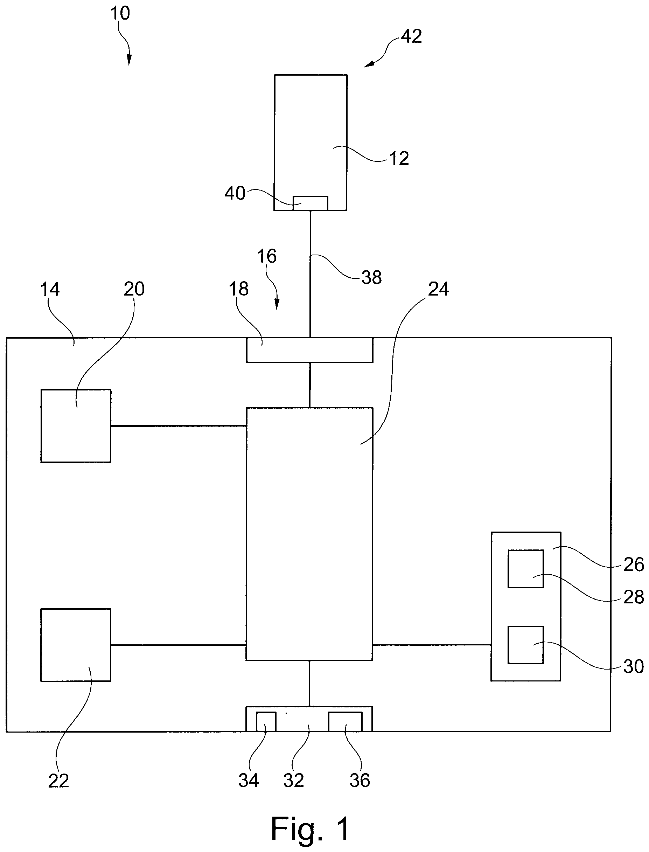

In Figure 1, a test system 10 is shown that comprises a device under test 12 as well as an integrated circuit card test unit 14 (ICC test unit).

The device under test 12 is connected to the integrated circuit card test unit 14 via an interface 16 of the integrated circuit card test unit 14 that is established by an integrated circuit card adaptor 18.

The integrated circuit card test unit 14 also comprises a first integrated circuit card slot 20 and a second integrated circuit card slot 22 wherein both, the first and the second integrated circuit card slot 20, 22, are connected to a switch unit 24. The first and the second ICC slots 20, 22 are configured to accommodate physical integrated circuit cards that may be inserted into the ICC slots 20, 22 appropriately. The physical integrated circuit cards may have a pre-programmed integrated circuit card profile (ICC profile).

The switch unit 24 is also connected to the integrated circuit card adaptor 18 and to an integrated circuit card controller 26. The ICC controller 26 is used for controlling the physical ICCs for the testing as will be described later. For this purpose, the integrated circuit card controller 26 comprises a writer unit 28 as well as a reader unit 30 as shown in Figure 1.

Further, the integrated circuit card test unit 14 has a switch control interface 32 that is configured to receive control signals for controlling the switch unit 24. Thus, the switch control interface 32 is also connected with the switch unit 24.

The switch control interface 32 comprises a power supply unit 34 for powering the integrated circuit card test unit 14. Further, the switch control interface 32 comprises a data transmission unit 36 for obtaining the appropriate data for controlling the switch unit 24 in an appropriate manner.

In general, the integrated circuit card test unit 14 is used for testing the device under test 12 wherein different physical integrated circuit cards and/or integrated circuit card profiles are used for the testing of the device under test 12, in particular its certificating.

For testing purposes, the switch unit 24 has a first operation mode in which a connection between either the first integrated circuit card slot 20 or the second integrated circuit card slot 22 and the integrated circuit card adaptor 18 is established via the switch unit 24. Thus, the physical integrated circuit card inserted in one of the slots 20, 22 is used for testing the device under test 12 that is connected to the integrated circuit card adaptor 18.

This connection may be established by a cable 38 that is connected to a SIM-card slot 40 of the device under test 12. Thus, the device under test 12 may be a mobile end device 42 such as a tablet, a smartphone or a mobile phone.

The switch unit 24 is further configured to change the connection such that the other integrated circuit card slot 20, 22 is connected with the integrated circuit card adaptor 18, in a second test step. Therefore, the device under test 12 can be tested differently while using the other physical integrated circuit card.

In general, the first operation mode of the switch unit relates to the connection of one of the integrated circuit card slots 20, 22 with the integrated circuit card adaptor 18 for testing purposes as the respective physical integrated circuit card is used.

Moreover, the switch unit 24 has a second operation mode in which a connection between either the first integrated circuit card slot 20 or the second integrated circuit card slot 22 and the integrated circuit card controller 26 is established via the switch unit 24.

In the second operation mode, one of both slots 20, 22 is connected to the integrated circuit card controller 26 such that the respective physical integrated circuit card that is inserted into the respective slot 20, 22 can be accessed by the ICC controller 26.

However, the same physical integrated circuit card cannot be connected via its respective ICC slot 20, 22 with the ICC controller 26 and the ICC adaptor 18 simultaneously.

In the second operation mode of the ICC test unit 14, the integrated circuit card controller 26 provisions a physical integrated circuit card with a predetermined integrated circuit card profile. Thus, the integrated circuit card that is inserted in the respective ICC slot 20, 22 connected to the integrated circuit card controller 26 via the switch unit 24 is provision with the predetermined integrated circuit card profile.

Generally, the first operation mode and the second operation mode may be established by a common operation mode of the integrated circuit card test unit 14 such that the device under test 12 is tested by a first physical integrated circuit card and a dedicated integrated circuit card profile whereas another physical integrated circuit card gets (re-)programmed via the integrated circuit card controller 26.

Thus, it is ensured that different integrated circuit card profiles can be used for testing purposes as the integrated circuit card controller 26 may overwrite the current integrated circuit card profile of the respective integrated circuit card during the testing of the device under test 12 with the other ICC that is not connected to the ICC controller 26.

After the (re-)programming and the testing have been finished, the switch unit 24 is controlled such that the connections are interchanged. Hence, the ICC previously used for testing gets connected to the ICC controller 26 in order to be (re-)programmed whereas the ICC previously (re-)programmed gets connected to the ICC adaptor 18 for testing the device under test 12. A manual exchange of the physical integrated circuit cards is no more required.

When (re-)programming the respective integrated circuit card, the integrated circuit card controller 26 initially reads out the current integrated circuit card profile via its reader unit 30 and rewrites the integrated circuit card profile or overwrites the current integrated circuit card profile via its writer unit 32.

As the switch unit 24 has at least two different operation modes as well as different switching positions during the dedicated test steps, the switch unit 24 has a switching matrix function in order to provide the different connections between the integrated circuit card slots 20, 22 and the integrated circuit card controller 26 and the integrated circuit card adaptor 18, respectively.

Hereinafter, a test scenario for testing a device under test 12 will be described with reference to Figure 1 in more detail.

In a first test step, a connection is established between one of both integrated circuit card slots 20, 22 and the integrated circuit card adaptor 18 such that the respective physical integrated circuit card is connected to the device under test 12 for testing purposes. For instance, the first ICC slot 20 is connected to the ICC adaptor 18 such that the inserted ICC can be used for testing the device under test 12.

Simultaneously, the switch unit 24 may establish a connection between the other integrated circuit card slot 20, 22, namely the second ICC slot 22, and the integrated circuit card controller 26 such that the integrated circuit card controller 26 can read out the current integrated circuit card profile of the respective physical integrated circuit card and overwrites the ICC profile if desired. Hence, the ICC gets programmed appropriately.

Both, the testing and the programming, may be done simultaneously in a common operation mode of the ICC test unit 14.

In a second test step, the switch unit 24 is controlled such that a connection between the integrated circuit card adaptor 18 and the other integrated circuit card slot 20, 22 is established, namely the second ICC slot 22. The integrated circuit card slot 20, 22 that gets connected to the adaptor 18 corresponds to the one that was previously connected with the integrated circuit card controller 26. Thus, the device under test 12 can now be tested with another physical integrated circuit card as well as another integrated circuit card profile.

In a similar manner, the integrated circuit card slot 20, 22 that was previously connected to the integrated circuit card adaptor 18, namely the first ICC slot 20, may now be connected to the integrated circuit card controller 26 in order to overwrite the ICC profile of the physical ICC in an appropriate manner if desired.

Accordingly, the device under test 12 can be connected with at least two different physical integrated circuit cards having different integrated circuit card profiles in a subsequent manner since the different profiles are (re-)programmed during the testing of the device under test 12 in an automatic manner.

These different steps are repeated until all combinations have been tested, particularly all ICC profiles.

Therefore, it is no more necessary that a manual exchange of the physical integrated circuit cards takes place as an automatic testing of the device under test 12 can be established. Thus, the testing of the device under test 12 can be carried out overnight.

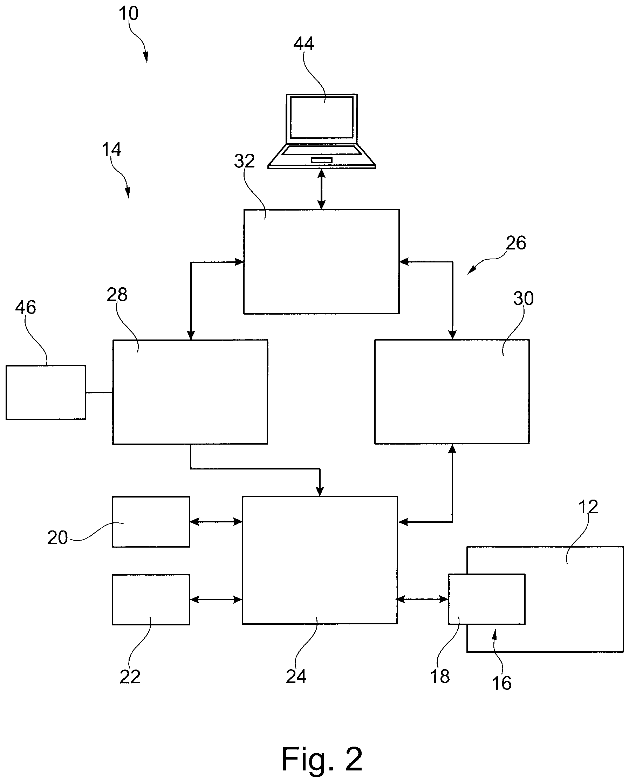

In Figure 2, a second embodiment of the test system 10 is shown that distinguishes from the first embodiment shown in Figure 1 in that the integrated circuit card controller 26 has two connections with the switch unit 24 wherein one of both connections is a unidirectional one, namely the connection between the writer unit 28 and the switch unit 24.

Further, it is shown that the ICC controller 26 may comprise the switch control interface 32 such that the control signals for the switch unit 24 are provided by a computer 44 wherein the appropriate control signals are processed by the ICC controller 26 and forwarded to the switch unit 24 for switching purposes. Thus, the switch unit 24 is indirectly connected to the switch control interface 32.

Moreover, a memory 46 is shown that is connected to the writer unit 28. The memory 46 may comprise the different ICC profiles that shall be used during the testing of the device under test 12. Thus, the writer unit 28 accesses the memory 46 for obtaining the relevant information of the different ICC profiles. Accordingly, the memory 46 may be established by an electrically erasable programmable read-out memory (EEPROM).

The ICC controller 26 of the ICC test unit 14 according to the first embodiment shown in Figure 1 may also comprise such a memory in which the respective ICC profiles are stored.

In general, an ICC test unit 14 is provided that is configured to perform automatic testing of the device under test 12 while automatically updating the ICC profiles of a physical ICC such that no manual exchange is needed.

## Claims

1. An integrated circuit card test unit (14) for testing a device under test (12), comprising:
- a first integrated circuit card slot (20),
- a second integrated circuit card slot (22),
- a switch unit (24),
- an integrated circuit card controller (26),
- an integrated circuit card adaptor (18) establishing an interface (16) for the device under test, and
- a switch control interface (32), wherein
the switch unit (24) is connected to the first integrated circuit card slot (20), the second integrated circuit card slot (22), the integrated circuit card controller (26), and the integrated circuit card adaptor (18), wherein
the switch unit (24) has at least a first operation mode in which a connection between either the first integrated circuit card slot (20) or the second integrated circuit card slot (22) and the integrated circuit card adaptor (18) is established via the switch unit (24), wherein
the switch unit (24) has at least a second operation mode in which a connection between either the first integrated circuit card slot (20) or the second integrated circuit card slot (22) and the integrated circuit card controller (26) is established via the switch unit (24), and wherein
the switch unit (24) is configured to selectively connect either the first or the second integrated circuit card slot (20, 22) to the integrated circuit card controller (26) and, respectively, the second or first integrated circuit card slot (22, 20) to the integrated circuit card adaptor (18).

2. The integrated circuit card test unit (14) according to claim 1, wherein the integrated circuit card controller (26) is configured to provision a physical integrated circuit card connected to the first integrated circuit card slot (20) or the second integrated circuit card slot (22) with a predetermined integrated circuit card profile.

3. The integrated circuit card test unit (14) according to claim 1 or 2, wherein the first operation mode and the second operation mode are established by a common operation mode, in particular wherein, in the common operation mode, a connection between the first integrated circuit card slot (20) and the integrated circuit card adaptor (18) and a connection between the second integrated circuit card slot (22) and the integrated circuit card controller (26) are established or wherein, in the common operation mode, a connection between the second integrated circuit card slot (22) and the integrated circuit card adaptor (18) and a connection between the first integrated circuit card slot (20) and the integrated circuit card controller (26) are established.

4. The integrated circuit card test unit (14) according to any of the preceding claims, wherein the integrated circuit card controller (26) comprises a writer unit (28) and/or a reader unit (30).

5. The integrated circuit card test unit (14) according to any of the preceding claims, wherein the switch control interface (32) comprises a power supply unit (34) and a data transmission unit (36).

6. The integrated circuit card test unit (14) according to any of the preceding claims, wherein the switch unit (24) has a switching matrix function.

7. A test system (10) for testing a device under test (12), wherein the test system (10) comprises a device under test (12) and an integrated circuit card test unit (14) according to any of the preceding claims.

8. The test system (10) according to claim 7, wherein the device under test (12) is connected with the integrated circuit card adaptor (18) via a cable (38), in particular wherein the cable (38) is connected to a SIM-card slot (40) of the device under test (12).

9. The test system (10) according to claim 7 or 8, wherein the device under test (12) is a mobile end device (42).

10. A method for testing a device under test (12) by using an integrated circuit card test unit (14), wherein, in a first test step, a connection between a first of at least two integrated circuit card slots (20) and an integrated circuit card adaptor (18) and a connection between the second integrated circuit card slot (22) and the integrated circuit card controller (26) is established, wherein the integrated circuit card adaptor (18) corresponds to an interface (16) for the device under test (12), wherein after a switching operation by a switch unit (24) in a second test step, a second of at least two integrated circuit card slots (22) is connected to the integrated circuit card adaptor (18), and wherein the first integrated circuit card slot (20) is connected to the integrated circuit card controller (26)

11. The method according to claim 10, wherein the first integrated circuit card slot (20) or the second integrated circuit card slot (22) is connected to an integrated circuit card controller (26) in order to program a physical integrated circuit card inserted with a predetermined integrated circuit card profile used for testing the device under test (12).

12. The method according to any of the claims 10 to 11, wherein the integrated circuit card test unit (14) is an integrated circuit card test unit according to any of the claims 1 to 6.

## Patentansprüche

1. Chipkartenprüfeinheit (14) zum Prüfen eines Prüfobjekts (12), mit:
- einem ersten Chipkartenschlitz (20);
- einem zweiten Chipkartenschlitz (22);
- einer Schaltereinheit (24);
- einer Chipkartensteuerung (26);
- einem Chipkartenadapter (18), der eine Schnittstelle (16) für das Prüfobjekt herstellt; und
- einer Schaltersteuerungsschnittstelle (32), wobei
die Schaltereinheit (24) mit dem ersten Chipkartenschlitz (20), dem zweiten Chipkartenschlitz (22), der Chipkartensteuerung (26) und dem Chipkartenadapter (18) verbunden ist, wobei
die Schaltereinheit (24) wenigstens einen ersten Betriebsmodus hat, in dem über die Schaltereinheit (24) eine Verbindung zwischen entweder dem ersten Chipkartenschlitz (20) oder dem zweiten Chipkartenschlitz (22) und dem Chipkartenadapter (18) hergestellt wird, wobei
die Schaltereinheit (24) wenigstens einen zweiten Betriebsmodus hat, in dem über die Schaltereinheit (24) eine Verbindung zwischen entweder dem ersten Chipkartenschlitz (20) oder dem zweiten Chipkartenschlitz (22) und der Chipkartensteuerung (26) hergestellt wird, und wobei
die Schaltereinheit (24) so eingerichtet ist, dass sie wahlweise entweder den ersten oder den zweiten Chipkartenschlitz (20, 22) mit der Chipkartensteuerung (26) und entsprechend den zweiten oder den ersten Chipkartenschlitz (22, 20) mit dem Chipkartenadapter (18) verbindet.

2. Chipkartenprüfeinheit (14) nach Anspruch 1, wobei die Chipkartensteuerung (26) so eingerichtet ist, dass sie eine mit dem ersten Chipkartenschlitz (20) oder dem zweiten Chipkartenschlitz (22) verbundene physische Chipkarte mit einem vorbestimmten Chipkartenprofil versieht.

3. Chipkartenprüfeinheit (14) nach Anspruch 1 oder 2, wobei der erste Betriebsmodus und der zweite Betriebsmodus von einem gemeinsamen Betriebsmodus hergestellt werden, insbesondere wobei im gemeinsamen Betriebsmodus eine Verbindung zwischen dem ersten Chipkartenschlitz (20) und dem Chipkartenadapter (18) und eine Verbindung zwischen dem zweiten Chipkartenschlitz (22) und der Chipkartensteuerung (26) hergestellt werden oder wobei im gemeinsamen Betriebsmodus eine Verbindung zwischen dem zweiten Chipkartenschlitz (22) und dem Chipkartenadapter (18) und eine Verbindung zwischen dem ersten Chipkartenschlitz (20) und der Chipkartensteuerung (26) hergestellt werden.

4. Chipkartenprüfeinheit (14) nach einem der vorhergehenden Ansprüche, wobei die Chipkartensteuerung (26) eine Schreibeinheit (28) und/oder eine Leseeinheit (30) umfasst.

5. Chipkartenprüfeinheit (14) nach einem der vorhergehenden Ansprüche, wobei die Schaltersteuerungsschnittstelle (32) eine Leistungsversorgungseinheit (34) und eine Datenübertragungseinheit (36) umfasst.

6. Chipkartenprüfeinheit (14) nach einem der vorhergehenden Ansprüche, wobei die Schaltereinheit (24) eine Schaltmatrixfunktion hat.

7. Prüfsystem (10) zum Prüfen eines Prüfobjekts (12), wobei das Prüfsystem (10) ein Prüfobjekt (12) und eine Chipkartenprüfeinheit (14) nach einem der vorhergehenden Ansprüche umfasst.

8. Prüfsystem (10) nach Anspruch 7, wobei das Prüfobjekt (12) über ein Kabel (38) mit dem Chipkartenadapter (18) verbunden ist, insbesondere wobei das Kabel (38) mit einem SIM-Kartenschlitz (40) des Prüfobjekts (12) verbunden ist.

9. Prüfsystem (10) nach Anspruch 7 oder 8, wobei das Prüfobjekt (12) ein mobiles Endgerät (42) ist.

10. Verfahren zum Prüfen eines Prüfobjekts (12) unter Verwendung einer Chipkartenprüfeinheit (14), wobei in einem ersten Prüfschritt eine Verbindung zwischen einem ersten von wenigstens zwei Chipkartenschlitzen (20) und einem Chipkartenadapter (18) und eine Verbindung zwischen dem zweiten Chipkartenschlitz (22) und der Chipkartensteuerung (26) hergestellt wird, wobei der Chipkartenadapter (18) einer Schnittstelle (16) für das Prüfobjekt (12) entspricht, wobei nach einem Schaltvorgang durch eine Schaltereinheit (24) in einem zweiten Prüfschritt ein zweiter von wenigstens zwei Chipkartenschlitzen (22) mit dem Chipkartenadapter (18) verbunden ist und wobei der erste Chipkartenschlitz (20) mit der Chipkartensteuerung (26) verbunden ist.

11. Verfahren nach Anspruch 10, wobei der erste Chipkartenschlitz (20) oder der zweite Chipkartenschlitz (22) mit einer Chipkartensteuerung (26) verbunden wird, um eine physische Chipkarte zu programmieren, die mit einem vorbestimmten Chipkartenprofil eingeführt wird, das zum Prüfen des Prüfobjekts (12) verwendet wird.

12. Verfahren nach einem der Ansprüche 10 bis 11, wobei die Chipkartenprüfeinheit (14) eine Chipkartenprüfeinheit nach einem der Ansprüche 1 bis 6 ist.

## Revendications

1. Unité de test (14) de carte à puce pour tester un dispositif sous test (12), comprenant :
- une première fente (20) pour carte à puce,
- une deuxième fente (22) pour carte à puce,
- une unité de commutation (24),
- une commande (26) de carte à puce,
- un adaptateur (18) de carte à puce qui établit une interface (16) pour le dispositif sous test, et
- une interface de commande de commutation (32), dans laquelle
l'unité de commutation (24) est reliée à la première fente (20) pour carte à puce, à la deuxième fente (22) pour carte à puce, à la commande (26) de carte à puce et à l'adaptateur (18) de carte à puce,
l'unité de commutation (24) présentant au moins un premier mode de fonctionnement dans lequel une liaison est établie via l'unité de commutation (24) entre la première fente (20) pour carte à puce ou la deuxième fente (22) pour carte à puce et l'adaptateur (18) de carte à puce,
l'unité de commutation (24) présentant au moins un deuxième mode de fonctionnement dans lequel une liaison est établie via l'unité de commutation (24) entre la première fente (20) pour carte à puce ou la deuxième fente (22) pour carte à puce et la commande (26) de carte à puce, et
l'unité de commutation (24) étant réalisée de manière à relier sélectivement la première ou la deuxième fente (20, 22) pour carte à puce à la commande (26) de carte à puce et respectivement la deuxième ou la première fente (22, 20) pour carte à puce à l'adaptateur (18) de carte à puce.

2. Unité de test (14) de carte à puce selon la revendication 1, dans laquelle la commande (26) de carte à puce est réalisée de manière à pourvoir une carte à puce physique reliée à la première fente (20) pour carte à puce ou à la deuxième fente (22) pour carte à puce d'un profil de carte à puce prédéterminé.

3. Unité de test (14) de carte à puce selon la revendication 1 ou 2, dans laquelle le premier mode de fonctionnement et le deuxième mode de fonctionnement sont établis par un mode de fonctionnement commun, en particulier dans laquelle, dans le mode de fonctionnement commun, une liaison entre la première fente (20) pour carte à puce et l'adaptateur (18) de carte à puce et une liaison entre la deuxième fente (22) pour carte à puce et la commande (26) de carte à puce sont établies, ou dans laquelle, dans le mode de fonctionnement commun, une liaison entre la deuxième fente (22) pour carte à puce et l'adaptateur (18) de carte à puce et une liaison entre la première fente (20) pour carte à puce et la commande (26) de carte à puce sont établies.

4. Unité de test (14) de carte à puce selon l'une des revendications précédentes, dans laquelle la commande (26) de carte à puce comprend une unité d'écriture (28) et/ou une unité de lecture (30).

5. Unité de test (14) de carte à puce selon l'une des revendications précédentes, dans laquelle l'interface de commande de commutation (32) comprend une unité d'alimentation électrique (34) et une unité de transmission de données (36).

6. Unité de test (14) de carte à puce selon l'une des revendications précédentes, dans laquelle l'unité de commutation (24) a une fonction de matrice de commutation.

7. Système de test (10) pour tester un dispositif sous test (12), dans lequel le système de test (10) comprend un dispositif sous test (12) et une unité de test (14) de carte à puce selon l'une des revendications précédentes.

8. Système de test (10) selon la revendication 7, dans lequel le dispositif sous test (12) est relié à l'adaptateur (18) de carte à puce par un câble (38), en particulier dans lequel le câble (38) est relié à une fente de carte SIM (40) du dispositif sous test (12).

9. Système de test (10) selon la revendication 7 ou 8, dans lequel le dispositif sous test (12) est un terminal mobile (42).

10. Procédé pour tester un dispositif sous test (12) en utilisant une unité de test (14) de carte à puce, dans lequel, dans une première étape de test, une liaison est établie entre une première d'au moins deux fentes (20) pour carte à puce et un adaptateur (18) de carte à puce et une liaison est établie entre la deuxième fente (22) pour carte à puce et la commande (26) de carte à puce, l'adaptateur (18) de carte à puce correspondant à une interface (16) pour le dispositif sous test (12), dans lequel, après une opération de commutation par une unité de commutation (24), une deuxième d'au moins deux fentes (22) pour carte à puce est reliée à l'adaptateur (18) de carte à puce dans une deuxième étape de test, et dans lequel la première fente (20) pour carte à puce est reliée à la commande (26) de carte à puce.

11. Procédé selon la revendication 10, dans lequel la première fente (20) pour carte à puce ou la deuxième fente (22) pour carte à puce est reliée à une commande (26) de carte à puce afin de programmer une carte à puce physique insérée avec un profil de carte à puce prédéterminé qui est utilisé pour tester le dispositif sous test (12).

12. Procédé selon l'une des revendications 10 à 11, dans lequel l'unité de test (14) de carte à puce est une unité de test de carte à puce selon l'une des revendications 1 à 6.
